# EUROPEAN PATENT APPLICATION

(11) **EP 4 579 755 A1**
(43) Date of publication of application: **02.07.2025**
(21) Application number: 24178022.0
(22) Date of filing: 24.05.2024
(51) Int. Cl.: H01L 29/06, H01L 29/08, H01L 29/10, H01L 29/737, H01L 29/165

(54) **VERTICAL HETEROJUNCTION BIPOLAR TRANSISTOR AND METHOD FOR ITS FABRICATION**

(30) Priority: 28.12.2023 EP 23220580
(71) Applicant: IHP GmbH - Innovations for High Performance Microelectronics / Leibniz-Institut für innovative Mikroelektronik, 15236 Frankfurt (Oder) (DE)
(72) Inventor: Heinemann, Bernd, 15236 Frankfurt (Oder) (DE); Rücker, Holger, 15236 Frankfurt (Oder) (DE); Grabolla, Thomas, 15236 Frankfurt (Oder) (DE)
(74) Representative: Eisenführ Speiser

(57) **Abstract**

A vertical heterojunction bipolar transistor comprises a collector region (Col), formed in a silicon substrate (1), and a shallow-trench isolation (2) that laterally isolates the collector region (Col) from other regions of the silicon substrate (1). A base connection region (BC) adjoins an inner transistor region (IT) at its inner lateral ends, and on its outer lateral sides extends laterally outwards above a fraction of the collector region (Col), but leaving room for a collector contact in a collector contact region (CC), and at its outer lateral ends forms a lateral wing section (BCW) that is laterally bounded by an isolating base connection spacer (s4). Underneath the lateral wing sections (BCW) of the base connection region, an air cavity (h) vertically extends from a back surface of the wing section (BCW) to a front surface of the collector region (Col).

## Description

The invention relates to a vertical bipolar transistor and a method for its fabrication. In particular, the present specification discloses a SiGe hetero bipolar transistor (HBT) and a fabrication method that can achieve a particularly high performance of the bipolar transistor in terms of high-frequency characteristics such as transit frequency (ft) and maximum frequency (fmax) values.

In particular, this application solves aspects of the design and processing of the base collector insulation, which improve the speed properties of SiGe HBTs and according to the state of the art are considered unsolved or insufficiently solved.

Bipolar transistors are used in a variety of ways in integrated analog and digital electronic circuits. In particular, bipolar transistors are used for high-frequency and high-speed applications due to their short switching times. The development of hetero bipolar transistors (HBTs) in particular has contributed to this. In HBTs, the emitter and base layers are made of different semiconductor materials, with the emitter having a larger band gap than the base. One example is the SiGe HBT, in which the emitter is made of silicon (Si) and the base contains a silicon-germanium alloy (SiGe).

Different approaches have been pursued for the production of SiGe HBTs suited for use in the high-speed range. The following publications are acknowledged:
i) DE10160509A1
ii) DE10358046 A1
iii) EP4199064A1
iv) K. K. Bourdelle et al, "The effect of as-implanted damage on the microstructure of threading dislocations in MeV implanted Si", J. Appl. Physics, vol. 86, pp. 1221-1225 (1999).
v) A. Gruhle: High-performance heterojunction bipolar transistors grown by molecular-beam epitaxy, J. Vac. Sci. Technol. B 11(3) pp. 1186-1189 (1993).
vi) B. Heinemann et al, "A Low-Parasitic Collector Construction for High-Speed SiGe:C HBTs", IEDM Tech. Digest (2004), pp. 252 - 254.
vii) L. J. Choi et al, "A Novel Isolation Scheme featuring Cavities in the Collector for a High-Speed 0.13µm SiGe:C BiCMOS Technology," SiRF Digest (2007), pp. 158 - 161.
viii) S. van Huylenbroeck et al, "A 400GHz fmax fully self-aligned SiGe:C HBT architecture," Proc. BCTM (2009), pp. 5 - 8.
ix) A. Fox et al, "Advanced heterojunction bipolar transistor for half-THz SiGe BiCMOS technology," IEEE Electron Device Lett, vol. 36, no. 7, pp. 642-644, Jul. 2015.
x) B. Heinemann et al, "SiGe HBT with fT/fmax of 505GHz/720GHz," 2016 International Electron Devices Meeting, 2016, pp. 3.1.1-3.1.4.
xi) W. Liebl et al., "SiGe Applications in Automotive Radars," ECS Trans. vol. 75, no. 8, pp. 91-102, 2016.
xii) H. Rücker and B. Heinemann, "Device Architectures for High-speed SiGe HBTs," in IEEE BiCMOS and Compound Semiconductor Integrated Circuits and Technology Symposium, BCICTS, 2019.
xiii) Schröter et al., "SiGe HBT technology: Future trends and TCAD based roadmap," Proc. IEEE vol. 105, pp. 1068-1086 (2017).
xiv) H. Rücker and B. Heinemann, "SiGe HBT Technology," in Silicon-Germanium Heterojunction Bipolar Transistors for mm-Wave Systems: Technology, Modeling, and Circuit Applications, N. Rinaldi and M. Schröter, Eds. Gistrup and Delft: River Publishers, 2018, pp. 11-45.

The type of base epitaxy has a significant impact on the design of the manufacturing process of HBTs. The so-called double polysilicon technology with selective base epitaxy has proven to be particularly attractive because it allows transistors to be produced at moderate cost which are self-aligned in essential parts, namely external base connection to emitter and emitter to collector. In the technology group with differential, non-selective base epitaxial growth (NSEG), there are both self-aligned and non-self-aligned base-emitter arrangements. In order to decouple the vertical expansion of the external base layer from the thickness requirements of a cap layer and an inner base layer, processes with a reinforcement in height of the base connection region have become established in the NSEG group.

Another way of differentiating the processes for manufacturing high-speed HBTs concerns the type of lateral insulation of the highly doped collector layer. In general, epitaxially buried, highly conductive areas are introduced, which are laterally separated from the substrate by deep trenches (DTs) that are completely or partially filled with insulator material. However, the production of the currently fastest SiGe HBTs, as described in the publication x), does not require the use of this "DT-insulated, epitaxially buried sub-collector" design feature. Here, the lateral insulation of a relatively flat, highly doped collector layer to the substrate is taken over by STI areas, and an insulator layer above the substrate surface is used for the dielectric insulation of the external base layer. The publication x) also introduced a formation of a selectively implanted collector (SIC) using a hard mask in combination with inside spacers. This avoids the disadvantage of a resist mask with regard to lateral resolution. As a result, smaller base-collector capacitances can ultimately be achieved without deterioration of the collector resistance. A detailed description of fabrication steps that allow fabricating of a HBT with the performance demonstrated in the publication x) is disclosed in publication iii).

The performance of HBTs in the high-speed range has thus been significantly increased by vertical and lateral scaling of the transistor dimensions and by the introduction of epitaxially produced base layers. Whether the high-frequency characteristics of modern SiGe HBTs can be further improved depends on how developing potentials of lateral and vertical scaling can be exploited to minimize internal transit and charging times as well as external parasitic effects such as external base resistance, emitter and collector resistances or external base-emitter and base-collector capacitances.

The bipolar transistor of the present invention, which is defined in claim 1 and will be presented in the following, provides a solution for further reducing the product of the collector resistance and base-collector capacitance (R_{C} x C_{CB}) in a particular transistor architecture known in particular from publication x), without requiring a modification of this transistor architecture. This achieves a reduction of the delay time and thus improves high-speed properties of the transistor.

The vertical heterojunction bipolar transistor of the present invention comprises
- a collector region formed in a silicon substrate;
- a shallow-trench isolation that laterally isolates the collector region from other regions of the silicon substrate;
- an inner transistor region, which comprises, epitaxially deposited on the collector region, a single crystalline heterojunction layer sequence, and which comprises, laterally embedded by an electrically isolating emitter-base spacer, an emitter on the single crystalline layer sequence;
- a base connection region, which at its inner lateral ends adjoins the innertransistor region, and which on its outer lateral sides extends laterally outwards above a fraction of the outer collector region, and which at its outer lateral ends forms a lateral wing section that is laterally bounded by an isolating base connection spacer; wherein,
- underneath the lateral wing sections of the base connection region, an air cavity vertically extends from a back surface of the first wing section to a front surface of the outer collector region.

The bipolar transistor of the present invention is based on the recognition that a use of low-k dielectric material offers the possibility for reducing the base-collector capacitance without changing the general transistor architecture. A particularly large reduction is achieved with the present invention by a processing that enables the fabrication of so-called air gaps (air cavities) to form at least a part of the dielectric.

While a reduction of the external base-collector capacitance by air cavities is per se known from the publications v) and vii), the fabrication steps applied in these publications do not provide any process that could be used to create any pre-specified shape of an air cavity between the external base and collector regions with a precision and reproducibility that is required in an industrial fabrication process, and in particular cannot be used to incorporate air gaps into a particular HBT architecture that is based on the design known from publication x). For example, Choi, in publication vii), uses an HBT arrangement with a deep-trench-insulated, epitaxially buried sub-collector and STI regions for lateral isolation of the inner transistor region and collector connection. Narrow trenches are created by hollowing out an epitaxially buried SiGe auxiliary layer using suitable etching processes, and (partially) filled with silicon dioxide in the course of the STI fabrication. Even if it is possible to find a technology that exploits this manufacturing detail to create the desired cavities and at the same time approximates the favored design of publication x), fundamental disadvantages remain. These include a lateral expansion of the under-etched SiGe layer, which is determined by the etching time only and therefore lacks precision and reproducibility, and restrictions that, at least in the HBT, result from the implementation of the additional SiGe auxiliary layer for technological flexibility and electrical operation.

The present invention allows using the general design and processing features of the SiGe-HBT technology known from publication x), including a collector area that is laterally enclosed by STI, a base that may be non-selectively deposited epitaxial base layer, a self-aligned base-emitter (BE) arrangement and a base connection region that may be epitaxially reinforced. The invention allows providing this particular HBT design that is able to achieve record parameters in its high-speed characteristics, with air cavities in the external base connection area and discloses a method for fabricating it. The air cavities further reduce the parasitic collector-base capacitance.

For this purpose, the fabrication process includes the use of insulation areas between the external base area and the collector, here called temporary substrate cover layer, which are specially introduced and partially or completely removed in a later process sequence. This allows to achieve a presence of air cavities between the base connection area and the collector area at the end of the manufacturing process.

However, the application of the design details or process steps according to the invention is not limited to the technology variant used in the examples described. The application of the measures proposed here is also possible, for example, in any other HBT technology that employs selective base epitaxy.

In particular, air cavities as proposed in the present invention are also applicable for HBT architectures that in their fabrication process use standard-sized STI regions in order to isolate base connection regions from outer collector regions. However, these architectures will in general take less advantage of the replacement of the isolation oxide by air gaps due to a larger thickness of an STI region in comparison to the isolation areas of the temporary substrate cover layer introduced above. In the following, embodiments of the vertical heterojunction bipolar transistor of the invention will be described.

In one embodiment of the heterojunction bipolar transistor, lateral extensions of the air cavities underneath the lateral wing sections begin at the outer lateral ends of the base connection region and end laterally closer to the inner transistor region. Seen in a cross-sectional view, the lateral extensions of the air cavities on both sides of the inner transistor region may be identical. However, while such identical lateral extensions are advantageous in terms of processing simplicity, that is not a requirement. Lateral extensions of the air cavities on those sides that are not visible in a given cross-sectional view may vary from the lateral extensions on those sides that are visible.

In preferred embodiments, the single crystalline heterojunction layer sequence of the inner transistor region is formed by a vertical sequence of a selectively implanted collector region made of silicon that is laterally embedded in a lateral section of a silicon buffer layer, a vertical section of the silicon buffer layer, an inner base region of silicon germanium, and an inner cap layer of silicon or silicon germanium. Certain variations of this heterojunction layer sequence of the inner transistor region are possible. For instance, the silicon buffer layer may be omitted.

In this embodiment, the lateral cavity reaches from the respective lateral outer ends of the wing sections to an outer lateral end of the buffer layer in the inner transistor region. The air cavity may be laterally closed at their outer lateral ends by base connection spacers of insulating material.

The base connection region of an HBT according to publication x) comprises a polycrystalline layer sequence of an outer buffer layer, an outer base region, and an outer cap region, and which further comprises a polycrystalline height-extension layer on the outer cap region. Alternatively, the base connection region can be formed by single-crystalline semiconductor material for an HBT with selective base epitaxy. The proposed fabrication process of air cavities between base connection regions and outer collector regions is applicable for HBT structures with poly-crystalline and with single-crystalline base connection regions.

A further aspect of the invention relates to a method for fabrication of a vertical heterojunction bipolar transistor. The method comprises:
- in a silicon substrate, fabricating a collector region and an isolation layer arrangement that includes a shallow-trench isolation which laterally isolates the collector region from other regions of the silicon substrate and that includes an isolating temporary substrate cover layer which covers the collector region;
- simultaneously depositing,
   - epitaxially in an opening of the temporary substrate cover layer, a first vertical section of an inner transistor region, which comprises a single crystalline selectively implanted inner collector region (SIC) directly on the collector region, a single crystalline heterojunction layer sequence deposited thereon, and, laterally adjacent,
   - a vertical section of a base connection layer sequence on the temporary substrate cover layer;
- fabricating, laterally embedded by an isolating emitter-base spacer, an emitter as a second vertical section of the inner transistor region on the single crystalline layer sequence; wherein the method further comprises
- depositing and structuring a second vertical section of the base connection layer sequence, which at its inner lateral ends adjoins the innertransistor region, and which extends laterally outwards above a fraction of the outer collector region, but leaves room for a collector contact on the outer collector region;
- fabricating at the outer lateral ends of the base connection region a lateral wing section that is laterally bounded by an isolating base connection spacer; wherein fabricating the lateral wing section comprises
- fabricating an air cavity underneath the lateral wing section on the base connection region, which air cavity vertically extends from a back surface of the wing section to a front surface of the outer collector region, by removing the temporary substrate cover layer underneath the lateral wing section on the lateral sides of the base connection region.

The method of the invention achieves the fabrication of air cavities in the external base connection area to reduce the parasitic collector-base capacitance and further improve high-speed properties of the vertical heterojunction bipolar transistor. To this end, a suitable temporary substrate cover layer is initially deposited and removed in a later processing stage under the wing sections.

In the following, embodiments of the method will be described.

In one embodiment, a protective coating made of a protective layer or a protective layer combination is used to protect the emitter and the emitter-spacer, to enable the partially or complete removal of the temporary substrate cover layer in the later process sequence. The protective coating may be made of silicon oxynitride, or of a sequence of a SiOz layer and a silicon oxynitride layer, or of a sequence of a silicon nitride and a silicon dioxide layer.

In particular, in this embodiment, fabricating air cavities comprises, after depositing the second vertical section of the base connection region:
- depositing a protective coating made of a protective layer or a protective layer combination, which is suitable to protect the emitter and the emitter-base spacer from a wet etchant, on the second vertical section of the base connection region;
- dry chemical structuring of the protective layer or layer combination, of the base connection region, and of the underlying temporary substrate cover layer, whereby the isolating temporary substrate cover layer and side faces of the base connection region are laterally exposed;
- plasma-enhanced deposition of a silicon dioxide layer;
- fabrication of an isolating base-connection spacer on the exposed side faces of the base connection region;
- using the wet etchant to remove the silicon dioxide layer to create an opening under the base-connection spacer, and to hollow out the temporary substrate cover layer located under the lateral wing sections of the base connection region to fabricate air cavities.

The height of the opening between the base-connection spacer and the Si surface of the collector region is preferably adjusted to a range of between 10 and 30 nm, by a suitable selection of the silicon dioxide layer thickness and the wet etching time. The silicon dioxide layer is preferably made by plasma enhanced (PE) deposition. Setting the height of the lateral base-connection spacer may be performed by applying a suitable thickness of the PE SiO₂ layer.

In the following, further embodiments of the bipolar transistor and the method according to the invention will be described with reference to the drawings.
- Figs. 1 to 22: show illustrations of processing stages during a performance of an embodiment of the method according to the present invention; wherein
- Fig. 22: also illustrates an embodiment of a bipolar transistor according to the present invention.

The exemplary method disclosed in the following enables the production of high-speed bipolar transistors. In particular, the disclosed method is described as a part of an integrated bipolar and CMOS, and thus BiCMOS process. However, while the method is particularly suited for use in a BiCMOS process, it is not correspondingly restricted. The method may also be used without a combination with the fabrication of MOS structures.

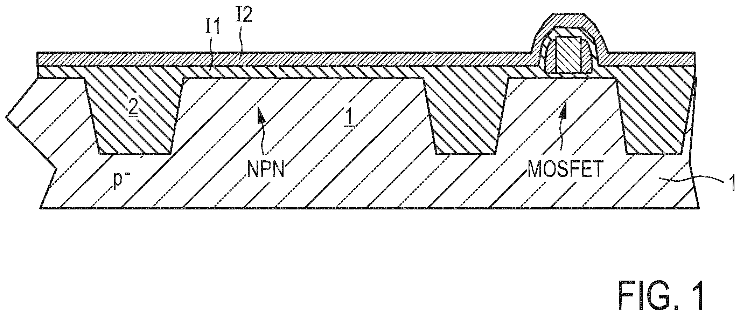

Referring to Fig. 1, the exemplary method involves a method for manufacturing an npn bipolar transistor (and thus any required number of such npn bipolar transistors) on a p-type substrate 1. The substrate 1 in the present example is a p⁻ silicon substrate, for instance in the form of a silicon wafer as used in the semiconductor industry for mass production of integrated circuits.

An active region of the substrate 1 for use in the fabrication of npn bipolar transistors, is labelled NPN. Another active region for use in the fabrication of an NMOS or PMOS structure such as a MOS-FET according to a CMOS technology is labelled MOSFET. It will be referred to as a CMOS active region in the following

At the processing stage illustrated in Fig. 1, most of the processing in the CMOS active regions has been performed already. In particular, in the CMOS active regions, n-type and p-type wells (not shown) and gates G made of polysilicon, shown here with lateral spacers Sp, are already present. It is noted that the MOS structure shown in Fig. 1 is of purely exemplary nature. Any other MOS structures known in the art may be fabricated using the process described herein. However, since the fabrication of MOS structures as such is not in the focus of the present invention, this is not shown or described in further detail.

Isolation regions of a first type have been structured on the substrate 1, which are shown in Fig. 1 under the reference label 2. These isolation regions are hereinafter referred to as field isolation regions 2. A shallow trench isolation (STI), which as such is well known in the semiconductor industry can be fabricated to form the field isolation regions 2. The trenches of the STI preferably extend 300 to 600 nm from the substrate surface into the substrate (i.e., in the depth direction pointing from the front side F to the back side B of the substrate 1), and may be filled with silicon dioxide (SiO₂, also referred to in short as "oxide" herein), for example, or with a combination of an insulator material and polysilicon. In alternative embodiments, the field isolation regions 2 are produced by means of local oxidation of silicon (LOCOS) process, which as such is a process also known in the semiconductor industry. The material for the field isolation regions 2 protrudes somewhat from the substrate surface and also extends laterally along the substrate surface in the active regions to form a first isolating substrate cover layer l1.

In a further processing step also illustrated in Fig. 1, an auxiliary layer l2 has been is deposited on the substrate 1. The auxiliary layer l2 may be implemented as a single layer or as a layer stack comprising two or more layers of different materials, for example silicon dioxide and silicon nitride.

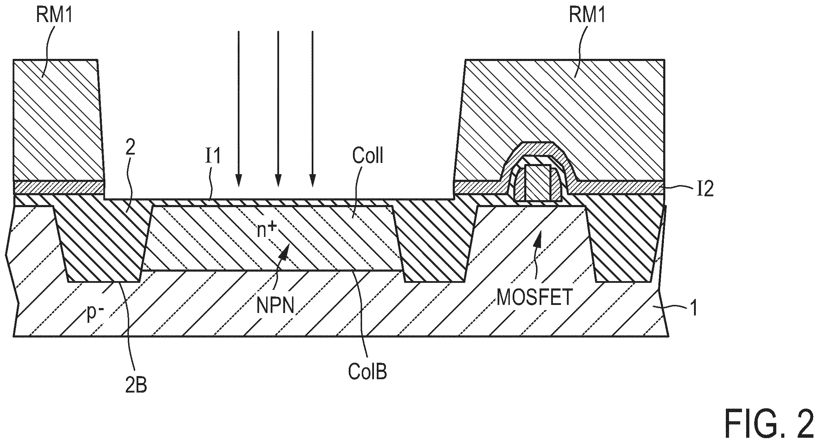

Subsequently, now with reference to Fig. 2, the auxiliary layer l2 is opened with the help of a first resist mask RM1 over the active regions HS-npn of the bipolar transistors (Fig. 2). The auxiliary layer l2 is structured by reactive ion etching (RIE), also known as dry etching. Before the resist mask RM1 is removed, the highly n-conductive collector region of the HS transistor, labelled Col, is created by masked ion implantation, which is indicated by arrows in Fig. 2. The collector regions Col of the bipolar transistors are laterally bounded by the field isolation regions 2. Preferably, the lower end face 2B of the field isolation regions 2 is lowerthan the lower end of the collector-side extent of the collector-substrate space charge zone, shown under the reference label ColB in Fig. 2, in order to keep the collector-substrate capacitance low.

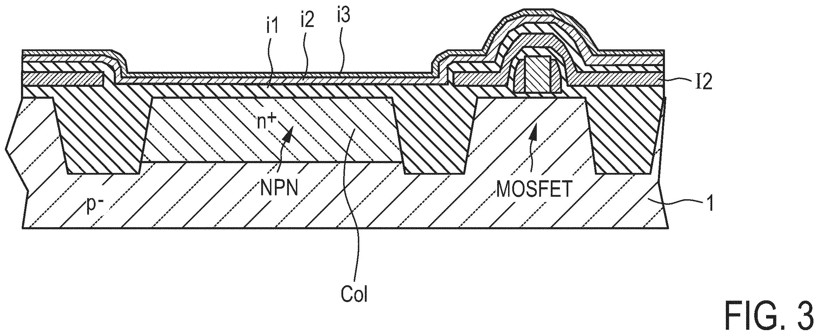

After removal of the first resist mask RM1 and usual wet chemical cleaning steps, the collector implants are subjected to heat treatment using rapid thermal processing (RTP) in order to reconstruct the crystal lattice of the substrate 1, which was disturbed during collector implantation, to achieve a minimal amount of defects. Residual oxide layers on the active areas NPN of the bipolar transistors may be removed, followed by subsequent deposition of the temporary substrate cover layer, which will be described below with reference to Fig. 3.

Referring to Fig. 3, the temporary substrate cover layer is then deposited on the substrate surface. The temporary substrate cover layer may be fabricated as a single layer or as a plurality of layers. It is preferred to use at least two layers, including a silicon dioxide layer and a silicon nitride layer on top of the silicon dioxide layer. In the present example, the isolation regions of the second type are fabricated as a stack of three layers, including two SiOz layers i1 and i2 and a silicon nitride layer i3, as described in the following.

The deposition process starts with the two silicon dioxide layers i1 and i2. A first oxide layer i1 is a LPCVD TEOS layer, i.e., a SiOz layer fabricated in a low-pressure chemical vapor deposition (LPCVD) process using Tetraethyl orthosilicate (TEOS) as a precursor. Another layer deposition process resulting in a SiO₂ layerthat is equivalent in terms of wet-chemical etching behavior may be used to fabricate the first oxide layer i1. For instance, a silicon dioxide layer fabricated by atomic layer deposition (ALD) is also suitable. The thickness of the first oxide layer i1 is between 15 nm and 100 nm, preferably between 25 and 50 nm.

Subsequently, a second oxide layer i2, preferably a PECVD-SiO₂ layer, i.e., a SiO₂ layer fabricated by plasma-enhanced chemical vapor deposition (PECVD) is deposited on top of the first oxide layer i1. The thickness of the second oxide layer i2 is between 25nm and 100nm, preferably between 50nm and 80nm.

The use of the second oxide layer i2 above the first oxide layer i1 achieves the possibility of exploiting a lower etching rate of PECVD oxides in hydrofluoric acid compared to TEOS. On the one hand, the etching rate, which is 1.5 to 3 times lower, reduces the lateral expansion of the collector window when exposing the substrate surface. On the other hand, the higher etch rate of TEOS causes an overhang of the PECVD oxide. This overhang offers more favorable possibilities for filling the inner transistor regions enclosed by the temporary substrate cover layer i1 and i2 with Si as horizontally and uniformly as possible without gaps and dislocations during subsequent selective epitaxy. Further criteria for the suitability of a special PECVD oxide are its edge coverage capability, but also the nucleation behavior during selective epitaxy.

To complete the layer stack of the isolation region formed by the temporary substrate cover layer, a silicon nitride (Si₃N₄) layer i3 is deposited over the double oxide stack of the layers i1 and i2. The silicon nitride layer i3 serves as an auxiliary layer for the later production of the inner transistor regions. The silicon nitride layer i3 is between 10 nm to 100 nm thick, preferably in the range between 20 nm to 50 nm.

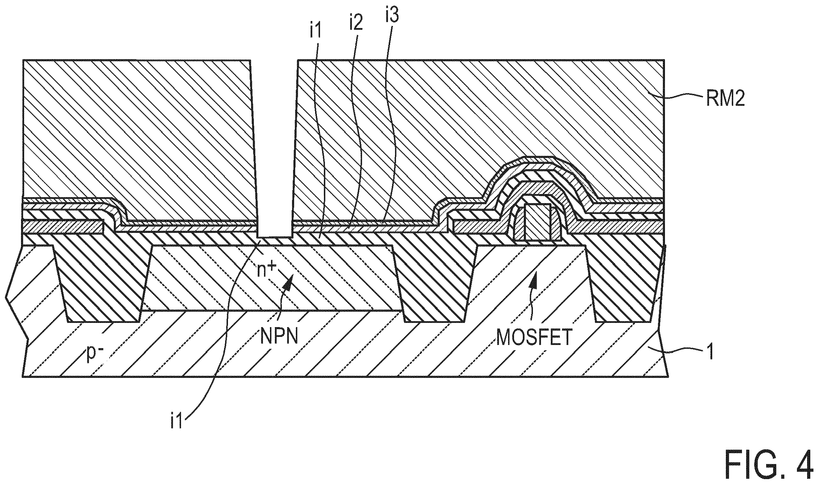

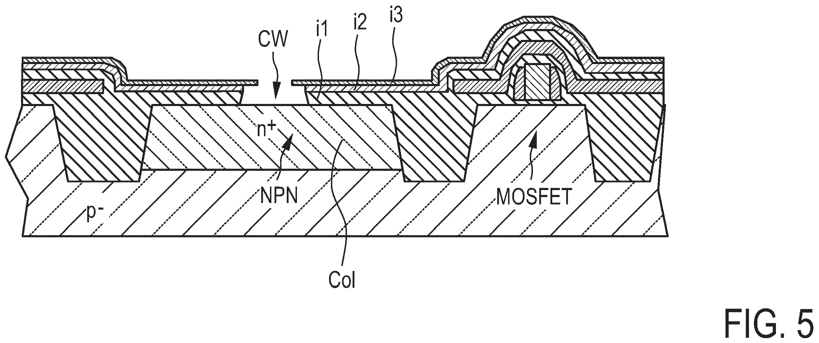

Referring now to Figs. 4 and 5 in parallel, with the aid of a photolithographically structured second resist mask RM2 and using a dry etching process, the silicon nitride layer i3 and the PECVD oxide layer i2 are removed to expose a collector window CW in the bipolar active regions NPN. The etching time of the dry etching step is adjusted so that the end of the etching process an etching front is formed at a position within the vertical extension of the first oxide layer i1. This achieves an effective decoupling of the residual oxide thickness and from a lateral widening of the collector window.

After removal of the second resist mask RM2, any remaining SiOz of the first oxide layer i1 in the collector window CW is removed using a chemical wet-etching process in order to expose the substrate surface. The oxide removal is preformed selectively with regard to the material of the silicon nitride layer i3.

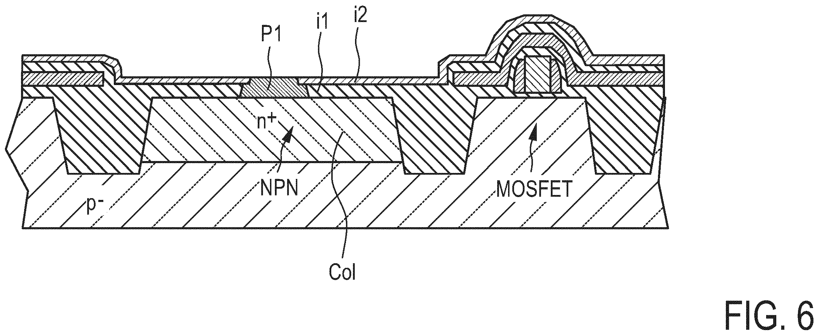

Referring to Fig. 6, the silicon nitride layer i3 is then selectively removed by wet chemical means, e.g. in hot phosphoric acid. On the inner areas of the bipolar transistor opened as described, a silicon buffer layer P1 is grown in the collector window CW using selective epitaxy.

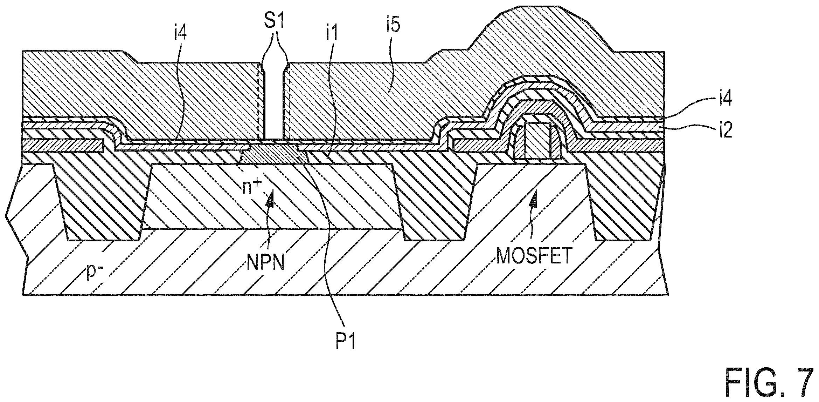

Referring now to Fig. 7, an auxiliary layer stack i4, i5, which serves as a hard mask for the selectively implanted collector SIC is then deposited on the temporary substrate cover layer i1, i2 and on the buffer layer P1. The auxiliary layer stack consists of a silicon dioxide layer i4, fabricated e.g. using a LPCVD-TEOS process, and a silicon nitride layer i5, fabricated e.g. by LPCVD. The silicon dioxide layer i4 is suitably between 10 nm and 40 nm thick, preferably between 20 nm and 30 nm. The silicon nitride layer i5 has a thickness of between 100 nm and 250 nm, preferably between 150 nm and 200 nm.

With the aid of a photolithographically structured resist mask (not shown), the silicon nitride layer i5 is removed by dry etching in a window over the inner transistor region of the bipolar transistors, with a stop on the silicon dioxide layer i4. After removing the resist mask, a silicon nitride auxiliary layer with a thickness of 10 nm to 50 nm, preferably 20 nm to 40 nm, is deposited (not shown) and a spacer s1 is formed on the side walls of the window opened in i5 on the basis of known dry etching processes.

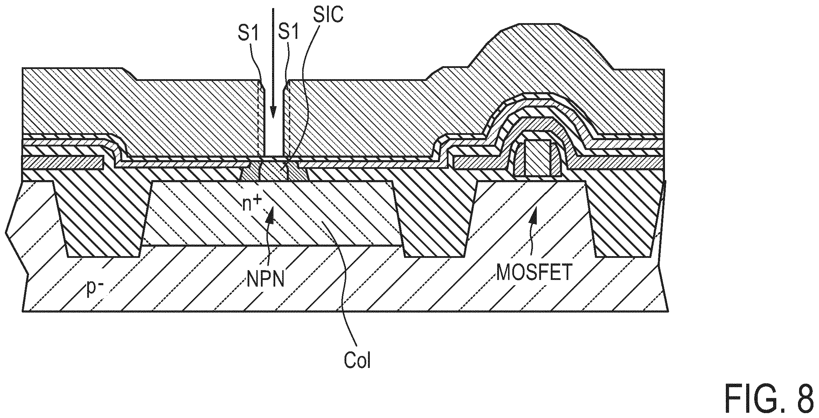

Referring to Fig. 8, collector type dopants are then implanted (as indicated by an arrow) to form the selectively implanted collector SIC. Implantation damage is then removed by a heat treatment.

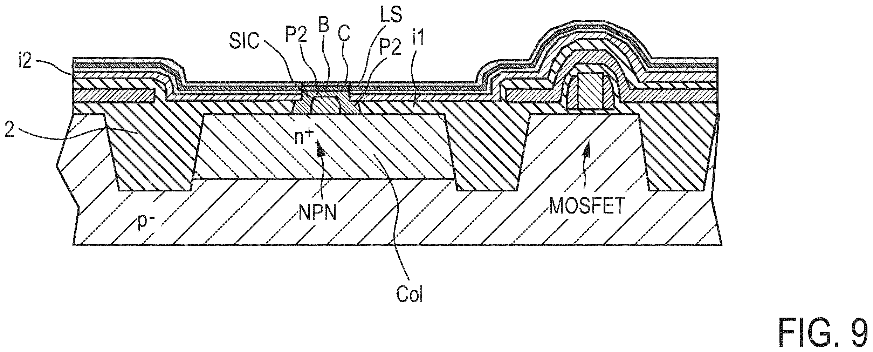

Next, with reference to Fig. 9, the Si₃N₄ layers i5 and s1 are removed using suitable etching agents, e.g. hot phosphoric acid. Care is taken to ensure that the surface of the freshly implanted buffer P1 with the selectively implanted collector region SIC remains covered with SiOz during the removal of these layers.

Next, the Si₃N₄ layers i5 and s1 are removed using suitable etching agents, e.g. hot phosphoric acid. Care is taken to ensure that the surface of the freshly implanted buffer P1 remains covered with SiOz during the removal of these layers.

The fabrication of the base then starts with a selective epitaxial step in which a thin buffer layer P2 of silicon is grown on the Si buffer P1 in the collector window before the monocrystalline base layer B and the monocrystalline Si cap layer C are produced in a non-selective epitaxial step. In particular, the base layer B can contain a SiGe layer and doping with carbon. The p-doping of the intrinsic base is introduced in-situ during layer growth. A polycrystalline Si/SiGe/Si layer stack LS grows on the exposed insulation areas 2 (Fig. 9).

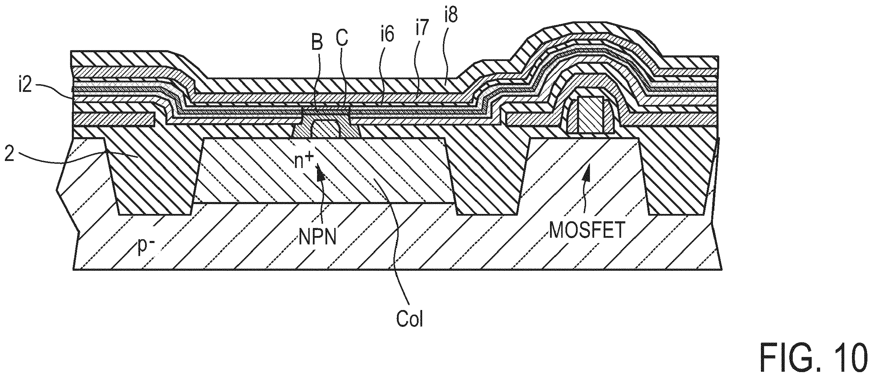

Referring next to Fig. 10, a layer stack i6, i7, i8 of an auxiliary layers, namely, a LPCVD-TEOS layer i6, a silicon nitride layer i7, and a PECVD oxide layer i8 is deposited over the cap layer C. The LPCVD-TEOS layer 6 preferably has a thickness of 3 nm to 20 nm. The silicon nitride layer i7 has a thickness of, for example, 30 nm to 100 nm. The thickness of the PECVD oxide layer i8 can be from 50 nm to 150 nm, for example. After deposition, the auxiliary layer stack i6, i7, i8 is subjected to a short-time temperature treatment. Temperatures of less than 850°C, preferably less than 750°C, and a treatment duration of less than 5 minute are suitably used. The use of PECVD silicon dioxide in the auxiliary layer i8 and its short-time temperature treatment reduce a widening of the emitterwindow in subsequent wet-chemical processes.

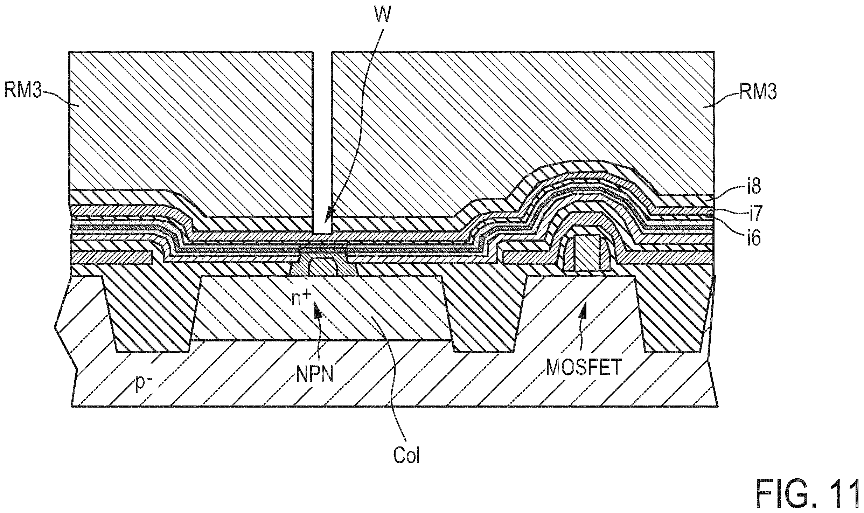

Referring to Fig. 11, a resist mask RM3 is used to open a window W in the PECVD oxide layer i8 and partially or completely in the silicon nitride layer i7, to define an active emitter surface. The window W is also referred to as the emitter window. The PECVD oxide layer i8 is structured by RIE. Until the silicon nitride layer i7 is reached, this anisotropic dry etching uses etching conditions that ablate i7 only slightly, as indicated in Fig. 11, or not at all. With the introduction of narrower pattern widths through advances in lithographic methods and in conjunction with advanced dry etching processes, it may also be advantageous to completely remove i7 in the emitter window W.

The resist mask RM3 is then removed, and the auxiliary layer i7 is further opened up, for example using an isotropic wet etching process. The wet etching process selectively etches the silicon nitride layer i7, but not the auxiliary LPCVD-TEOS layer i6 and the PECVD oxide layer i8, because the two latter are made of silicon dioxide. The isotropic etching makes it possible to actively control the widening of the opening of the silicon nitride layer i7 and its lateral shape.

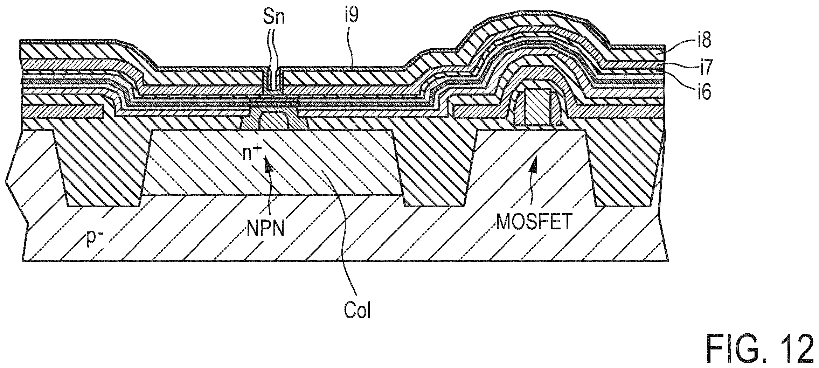

With reference to Fig. 12, this is followed by the formation of an emitter-base spacer. In a first step, an insulator layer i9 is deposited, which is made of a special silicon dioxide layer and has a thickness of 10 nm to 50 nm. For fabricating the insulator layer i9, a special LPCVD-SiOz deposition technique is used, based on the carrier gas bis(tertiary-butyla-mino)silane (BTBAS). This has the advantage over the use of LPCVD-TEOS that the etch rate in diluted hydrofluoric acid is up to a factor of 2 lower.

The process continues with the deposition of a 5 nm to 50 nm, preferably 10 nm to 25 nm thick, silicon nitride layer, e.g. LPCVD silicon nitride (not shown). The silicon nitride layer is etched back using an anisotropic RIE process, to form auxiliary spacers sn within the open emitter window W. The dry etching of the silicon nitride layer is preferably performed in such a way that the removal of this layer is detected via an endpoint mechanism, which reacts to the change in the proportion of certain etching products, and the etching process is stopped.

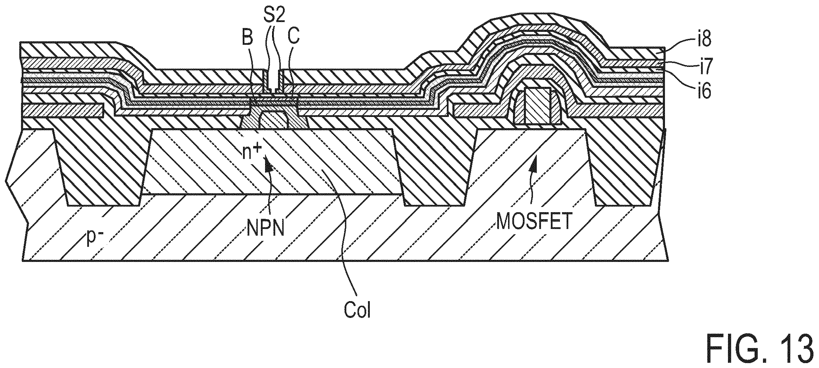

Referring to Fig. 13, the insulator layer i9 and the auxiliary layer i6 in the emitter window W as well as the insulator layer i9 and partially the auxiliary layer i8 in the remaining exposed areas are removed by wet etching with dilute hydrofluoric acid. This exposes the silicon cap layer C in the emitter window W and creates emitter-base spacers s2 on the side walls of the emitter window W, protected by the Si₃N₄ auxiliary spacers (not shown in Fig. 13).

The auxiliary spacers sn are then removed in hot phosphoric acid, leaving behind the emitter-base (EB) spacers s2, as shown in Fig. 13. The width of the EB spacers is determined on the one hand by the deposition thickness of the insulator layer i9 and on the other hand by the lateral, wet-chemical etching of the silicon nitride auxiliary layer i7 in hot phosphoric acid.

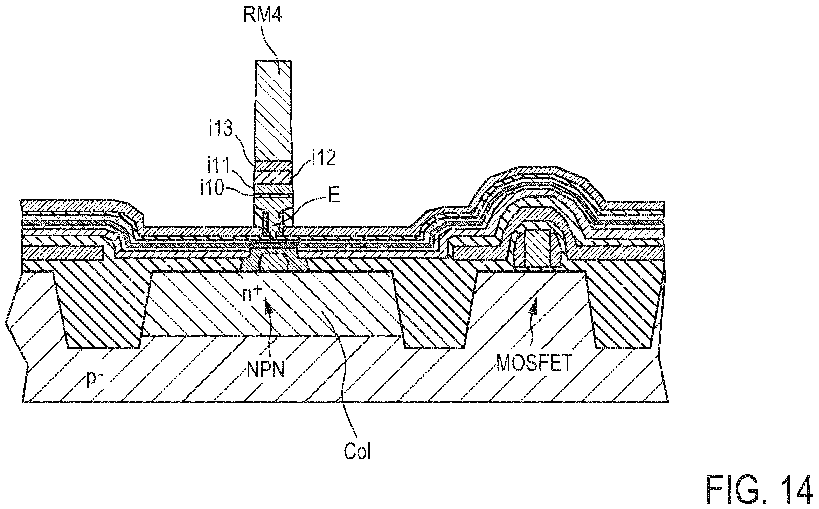

Referring next to Fig. 14, in a further step, an emitter E is deposited epitaxially. The emitter is preferably made of silicon, which is provided in-situ with an n⁺ doping, preferably arsenic. In the area of the emitter window W, the emitter E can be monocrystalline or polycrystalline. Usually, a wet cleaning in diluted hydrofluoric acid is used before the epitaxial step to remove thin oxide layers above the silicon surface in the emitter window and to saturate free bonds on the Si surface with hydrogen. It is not uncommon to carry out a temperature treatment between 800°C and 900°C in a hydrogen atmosphere in the epitaxy reactor before the deposition phase in order to remove residual oxygen between the cap C and the emitter layer E in the emitter window W. Above the emitter layer E, a quadruple stack i10, i11, i12 and i13 is deposited. The layer i10 preferably is a SiOz layer that is a few nm thick, a subsequent silicon nitride layer i11 above preferably is 30 nm to 70 nm thick, and the thicknesses of i12 and i13 are between 20 nm and 80 nm.

The emitter layer E, the insulator layers i10, i11, i12 and i13 and, in the preferred process, also i8 are structured in a further step using a lacquer mask RM4, as shown in Fig. 14.

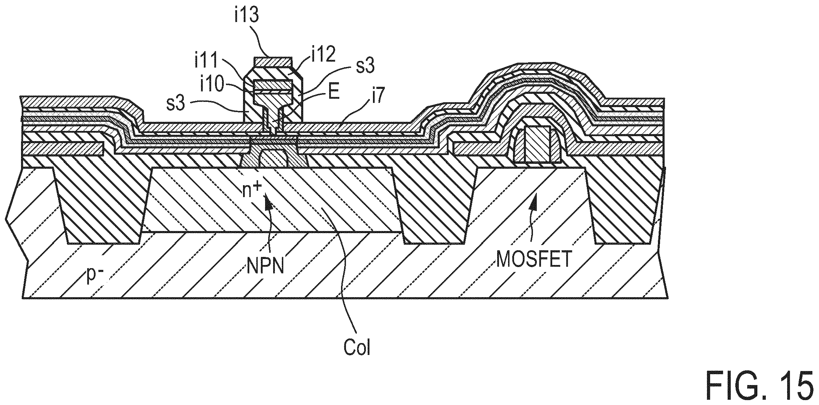

Referring then to Fig. 15, spacers s3, made of silicon dioxide for example, are then produced on those side surfaces of the emitter E that face outwards. During the subsequent spacer etching, the auxiliary layer i7 can be used as a stop layer.

The Si₃N₄ layers i7 and i13 are then removed, using for example hot phosphoric acid. This selective wet etching process removes i7 and i13, but not the coating of the emitter formed from silicon dioxide, such as i8, s3 and i12, and also not the remains of the auxiliary layer i6 that consists of SiOz.

The surface of the cap layer C is exposed in the areas outside the emitter, i.e. on the external base connection areas, by wet etching (not shown).

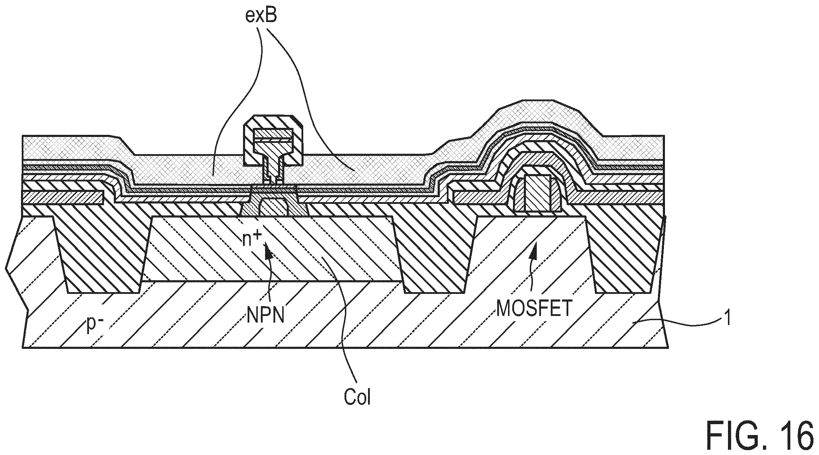

Referring to Fig. 16, a polycrystalline height-extension layer exB of the base connection region is grown on the exposed surface of the cap layer C using selective epitaxy. The p-doping of the base connection layer, which is preferably pre-doped in-situ during the epitaxy step, is preferably further increased by ion implantation.

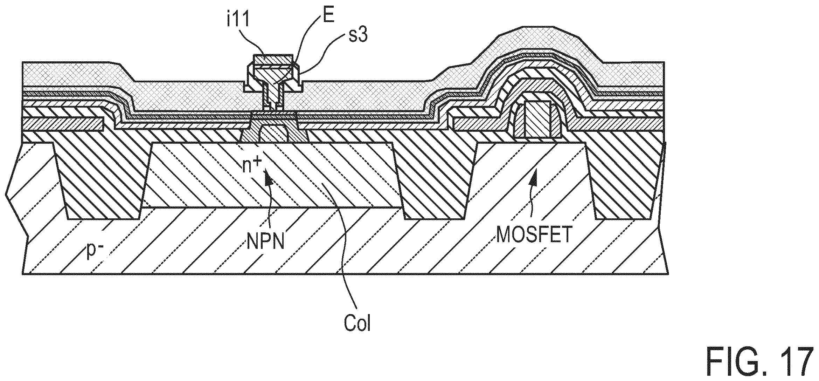

With reference to Fig. 17, in connection with the creation of air cavities between the base and collector connection, the SiO₂ layer i12 is wet-chemically removed partially from the emitter E in diluted hydrofluoric acid at this point and completely removed at least above the emitter E.

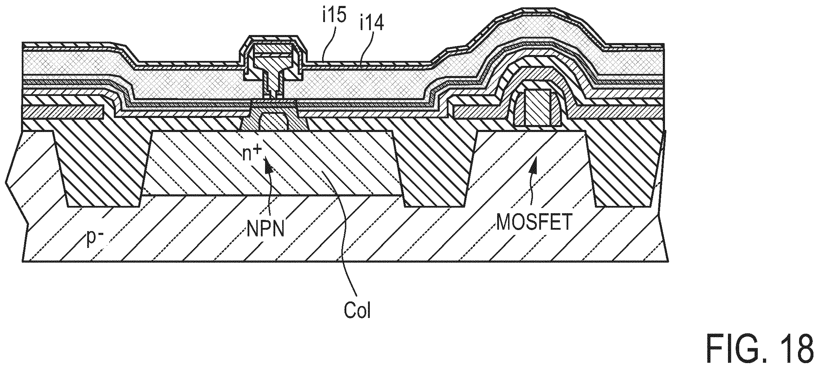

With reference to Fig. 18, in the present exemplary embodiment, a protective layer stack consisting of a silicon nitride layer i14 and a silicon dioxide layer i15 is then applied.

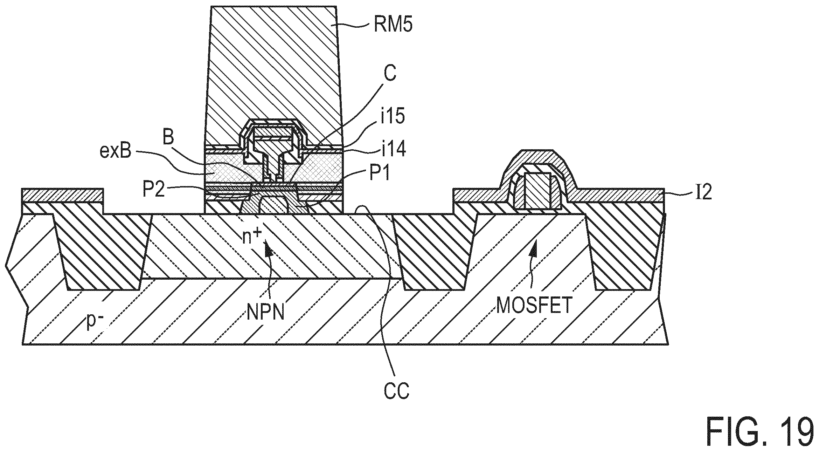

Referring next to Fig. 19, with the aid of a further resist mask RM5, the protective layer stack i14, i15 and the epitaxial layers P1, B, C and exB are removed down to the collector connection region CC in the NPN region, and down to auxiliary layer l2 outside NPN regions. An RIE process can be used for this, which stops on the auxiliary layer i2 or preferably completely removes the layers i1 and i2 of the temporary substrate cover layer, as shown in Fig. 19. The CMOS regions are thus in the same state as before the deposition of the layers i1 and i2 of the temporary substrate cover layer.

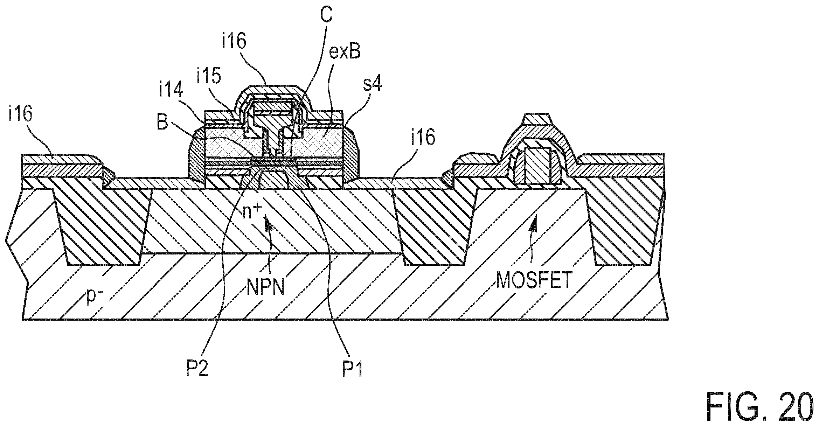

Referring to Fig. 20, for further preparing the fabrication of air cavities, a plasma-enhanced (PE) silicon dioxide deposition is now used. By appropriately selecting a deposition thickness and a following dwell time of a PE layer i16 in diluted hydrofluoric acid, it is possible to expose the RIE-etched side wall of the layer stack in the base connection area, consisting of the protective layer stack i14/i15, the epitaxial layers P, B, C and exB as well as the layers i1/i2 of the temporary substrate cover layer while maintaining part of the layer i16 on horizontal areas This is followed by the deposition of an oxynitride layer, from which a spacer s4 is formed by dry etching, as shown in Fig. 20. In this case, the implementation of a specially developed BTBAS oxynitride variant is used, which largely withstands the attack of diluted hydrofluoric acid. Coatings with this property can be specifically adjusted on the basis of the BTBAS system by adding nitrogen. This is achieved by the additional or alternative use (instead of O₂) of dinitrogen monoxide. The tests with this special BTBAS variant show that no further annealing is required after the BTBAS process in order to achieve stable properties.

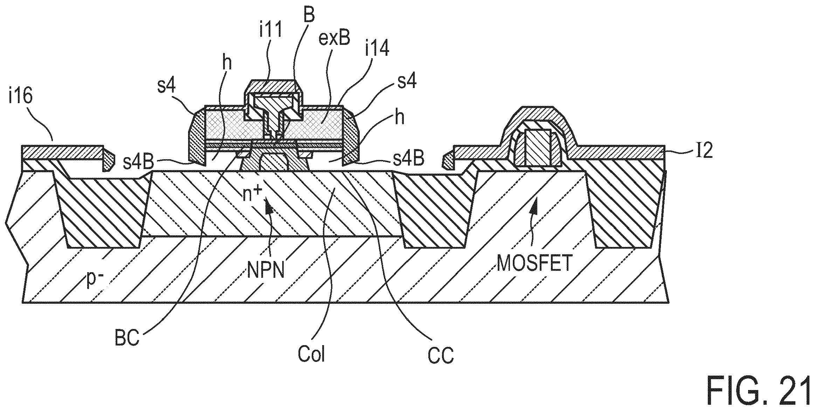

Referring to Fig. 21, a dry etching step takes advantage of the fact that oxynitride material can be removed highly selectively to form silicon dioxide using nitride etching RIE processes. In this way, a gap initially filled with SiOz at a defined distance of 10 nm to 25 nm can be created between the lower end s4B of the spacer s4 and the silicon surface of the collector connection region CC.

Using silicon dioxide etching wet etching processes, the remains of the PE silicon dioxide layer i16 and the SiOz auxiliary layer i15 of the protective layer stack i14/15 and the insulator layers i1/i2 located (cf. Fig. 20) under the external base connection area are then partially or completely removed, whereby the dielectric insulation between the base B and collector connection layer CC is partially formed by air cavities h. Depending on the used layer thickness of the temporary substrate cover layer i1/i2, the vertical extent of the air cavities h can assume values between 40 nm and 200 nm, with a preferred range between 75 nm to 130 nm.

The 10 nm to 25 nm gap between the spacer s4 and the silicon surface of the collector connection layer CC may be closed or covered during layer depositions later in the process (not shown). Even if, depending on the type of deposition, deposits reach the walls of the cavity h between the base connection area BC and the collector, a cavity h effective for reducing the base collector capacity is retained.

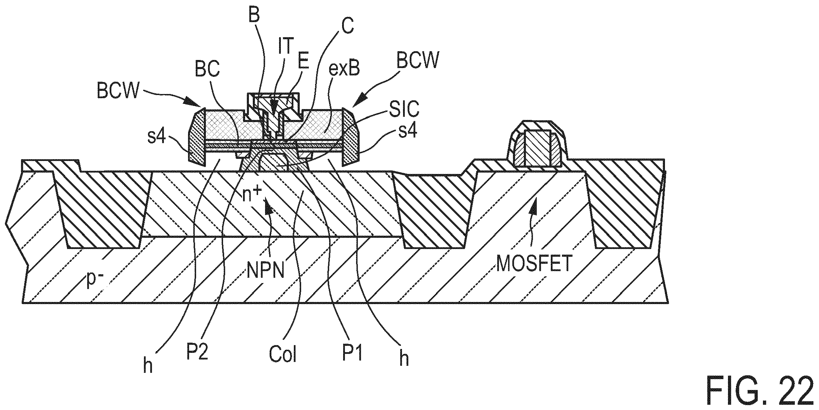

Reference is now made to Fig. 22. The residues of the Si₃N₄ layer i14 (cf. Fig. 21) over the base connection area and the emitter E as well as the Si₃N₄ layer i11 (cf. Fig. 21) over the emitter and the Si₃N₄ layer of the protective layer l2 (cf. Fig. 21) over the CMOS areas are then removed in hot phosphoric acid. This is followed by process steps such as source-drain and corresponding LDD/halo implantations, which complete the production of the CMOS transistors.

The vertical heterojunction bipolar transistor fabricated by the described processing may thus comprise
- a collector region Col, formed in a silicon substrate 1;
- a shallow-trench isolation 2 that laterally isolates the collector region Col from other regions of the silicon substrate 1;
- an inner transistor region IT, which comprises, epitaxially deposited on the col-lector region, an inner collector region SIC and a single crystalline heterojunction layer sequence P2, B, C, and, laterally embedded by an electrically isolating emitter-base spacer s2, s3, an epitaxially deposited emitter E on the single crystalline layer sequence;
- a base connection region BC, which at its inner lateral ends adjoins the inner transistor region IT, and which extends laterally outwards above a fraction of the collector region Col, and which at its outer lateral ends forms a lateral wing section BCWthat is laterally bounded by an isolating base connection spacer s4; wherein,
- underneath the lateral wing sections BCW of the base connection region, an air activity h vertically extends from a back surface of the wing section BCW to a front surface of the collector region Col.

Briefly highlighting certain features of the process described, following the production of the collector areas, the base formation, the fabrication of EB spacers and the deposition and structuring of the emitter layer and the possibly epitaxially grown reinforcement or filling of base connection areas, the following steps may be performed:
a) a protective layer or layer combination is deposited before structuring the base connection areas to protect the emitter arrangement, including the EB spacer arrangement, from wet etching processes (which are usually used to remove SiO2 or Si3N4),
b) dry chemical structuring of the base connection areas consisting of the protective layer/combination, a (poly-) Si layer and an underlying insulator layer/combination, whereby the lower insulator layer/combination and the collector connection area are exposed from the side,
c) deposition of a PE oxide layer;
d) partial, wet-chemical removal of the PE oxide layer, whereby the dry-etched side wall of the layer stack in the base connection area is exposed,
e) deposition and spacer etching of an oxynitride layer with stop on the remains of the PE oxide layer,
f) wet-chemical removal of the remains of the PE oxide layer and at least partial hollowing out of the insulator layer/combination located under the external base poly-Si region,
g) lateral closing of the opening to the air cavity under the base poly-Si region, which is formed between the oxynitride spacer and collector connection region, by PE oxide depositions and, if necessary, by spacer production

The composition of the protective coating/combination on the base connection area can be made of oxynitride or SiO2 / oxynitride or Si₃N₄ /SiO₂

The height of the opening between the oxynitride spacer and the Si surface of the collector connection area is adjusted preferably between 10 and 30 nm, by suitable selection of the PE oxide thickness and the wet etching time

The height of the lateral oxynitride spacer is set by applying a suitable thickness of the SiO₂ or Si₃N₄ nitride layer to the base connection area.

In summary, the invention disclosed herein relates to improvements of a vertical heterojunction bipolar transistor and to a method for fabrication of such an improved heterojunction bipolar transistor. The transistor comprises a collector region, formed in a silicon substrate, and a shallow-trench isolation that laterally isolates the collector region from other regions of the silicon substrate. A base connection region adjoins an inner transistor region at its inner lateral ends, and on its outer lateral sides extends laterally outwards above a fraction of the collector region, but leaving room for a collector contact in a collector contact region, and at its outer lateral ends forms a lateral wing section that is laterally bounded by an isolating base connection spacer. Underneath the lateral wing sections of the base connection region, an air cavity vertically extends from a back surface of the wing section to a front surface of the collector region.

## Claims

1. A vertical heterojunction bipolar transistor, comprising
- a collector region (Col), formed in a silicon substrate (1);
- a shallow-trench isolation (2) that laterally isolates the collector region (Col) from other regions of the silicon substrate (1);
- an inner transistor region (IT), which comprises, epitaxially deposited on the collector region, a single crystalline heterojunction layer sequence (P1, P2, B, C) forming part of the collector and the base of the inner transistor, and, laterally embedded by an electrically isolating emitter-base spacer (s2, s3), an epitaxially deposited emitter (E) on the single crystalline layer sequence;
- a base connection region (BC), which at its inner lateral ends adjoins the inner transistor region (IT), and which on its outer lateral sides extends laterally outwards above a fraction of the collector region (Col), but leaving room for a collector contact in a collector contact region (CC), and which at its outer lateral ends forms a lateral wing section (BCW) that is laterally bounded by an isolating base connection spacer (s4); wherein,
- underneath the lateral wing sections (BCW) of the base connection region, an air cavity (h) vertically extends from a back surface of the wing section (BCW) to a front surface of the collector region (Col).

2. The heterojunction bipolar transistor of claim 1, wherein lateral extensions of the air cavities (h) underneath the lateral wing sections (BCW) begin at the outer lateral ends of the base connection region (BC) and end laterally closer to the inner transistor region (IT).

3. The heterojunction bipolar transistor of claim 1 or 2, wherein the single crystalline heterojunction layer sequence (SIC, P2, B, C) of the inner transistor region is formed by a vertical sequence of a selectively implanted collector region (SIC) made of silicon that is laterally embedded in a lateral section of a silicon buffer layer (P1), a vertical section of the silicon buffer layer (P2), an inner base region (B) of silicon germanium, and an inner cap layer (C) of silicon or silicon germanium.

4. The heterojunction bipolar transistor of claim 3, wherein the lateral cavity (h) laterally extends from the lateral outer end of the wing section (BCW) to an outer lateral end of the buffer layer (P1).

5. The heterojunction bipolar transistor of claim 3 or 4, wherein the base connection region (BC) comprises an at least partially polycrystalline layer sequence of an outer buffer layer, an outer base region, and an outer cap region, and which further comprises a poly-crystalline height-extension layer (exB) on the outer cap region.

6. The heterojunction bipolar transistor of any of the preceding claims, wherein the air cavities (h) are laterally closed by base connection spacers (s4) of insulating material.

7. A method for fabrication of a vertical heterojunction bipolar transistor, comprising:
- in a silicon substrate, fabricating a collector region and an isolation layer arrangement (i1, i2, 2) that includes a shallow-trench isolation (2) which laterally isolates the collector region from other regions of the silicon substrate and that includes an isolating temporary substrate cover layer (i1, i2) which covers the collector region;
- depositing,
- epitaxially in an opening of the temporary substrate cover layer (i1, i2), a first vertical section of an inner transistor region, which comprises a single crystalline selectively implanted inner collector region (SIC) directly on the collector region, a single crystalline heterojunction layer sequence (P2, B, C) deposited thereon, and, laterally adjacent,
- an vertical section of a base connection layer sequence on the temporary substrate cover layer (i1, i2);
- fabricating, laterally embedded by an isolating emitter-base spacer (s2, s3), an emitter (E) as a second vertical section of the inner transistor region on the single crystalline layer sequence; wherein the method further comprises
- depositing and structuring a second vertical section (exB) of the base connection layer sequence, which at its inner lateral ends adjoins the inner transistor region, and which on a first lateral side extends laterally outwards above a fraction of the outer collector region, leaving room for a collector contact on the outer collector region, and on a second lateral side extends laterally outwards over the outer collector region and a fraction of the shallow trench isolation, to allow fabricating a base contact on its front surface that points in a vertical direction;
- fabricating at the outer lateral ends of the base connection region lateral wing sections that are laterally bounded by an isolating base connection spacer; wherein fabricating the lateral wing sections comprises
- fabricating an air cavity underneath a the lateral wing sections on the base connection region, which air cavity vertically extends from a back surface of the wing section to a front surface of the outer collector region, by removing the temporary substrate cover layer (i1, i2) underneath the lateral wing section on the lateral sides of the base connection region.

8. The method of claim 7, wherein fabricating air cavities comprises, after depositing the second vertical section (exB) of the base connection region,
- depositing a protective coating made of a protective layer or a protective layer combination (i14, i15), which is suitable to protect the emitter and the emitter-base spacer (s2) from a wet etchant, on the second vertical section (exB) of the base connection region;
- dry chemical structuring of the protective layer or layer combination (i14, i15), of the base connection region, and of the underlying isolating temporary substrate cover layer, whereby the isolating temporary substrate cover layer and side faces of the base connection region are laterally exposed;
- plasma-enhanced deposition of a silicon dioxide layer (i16);
- fabrication of an isolating base-connection spacer (s4) on the exposed side faces of the base connection region;
- using the wet etchant to remove the silicon dioxide layer to create an opening and der base-connection spacer, and to hollow out the temporary substrate cover layer located under the first and second lateral wing sections of the base connection region to fabricate the first and second air cavities.

9. The method of claim 8, wherein the protective coating is made of silicon oxynitride, or of a sequence of a SiOz layer and a silicon oxynitride layer, or of a sequence of a silicon nitride and a silicon dioxide layer.

10. The method of any of the claims 7 to 9, wherein depositing the temporary substrate cover layer (i1, i2) comprises fabricating a first silicon dioxide layer using a low-pressure chemical vapor deposition process using Tetraethyl orthosilicate, also known as TEOS, as a precursor, and fabricating a second silicon dioxide layer (i2) using a plasma-enhanced chemical vapor deposition process.

11. The method of claim 10, wherein the first silicon dioxide layer (i1) is fabricated with a first thickness of between 15 and 100 nm, and wherein the second the second silicon dioxide (i2) layer is fabricated with a thickness of between 25nm and 100nm.
